# EUROPÄISCHE PATENTSCHRIFT

(11) **EP 2 340 693 B1**
(45) Veröffentlichungstag und Bekanntmachung des Hinweises auf die Patenterteilung: **24.07.2019**
(21) Anmeldenummer: 09747800.2
(22) Anmeldetag: 08.10.2009
(51) Int. Cl.: H05K 1/18, H01L 23/00

(54) **VERFAHREN ZUM HERSTELLEN EINER ELEKTRISCHEN SCHALTUNGSANORDNUNG**
METHOD FOR PRODUCING AN ELECTRICAL CIRCUIT ARRANGEMENT
PROCÉDÉ DE FABRICATION D'UN CIRCUIT ÉLECTRIQUE

(30) Priorität: 23.10.2008 DE 102008043122
(43) Veröffentlichungstag der Anmeldung: 06.07.2011
(73) Patentinhaber: Robert Bosch GmbH, 70442 Stuttgart (DE)
(72) Erfinder: SCHAAF, Ulrich, 73667 Kaisersbach (DE); KUGLER, Andreas, 73553 Alfdorf (DE)
(86) Internationale Anmeldenummer: PCT/EP2009/063103
(87) Internationale Veröffentlichungsnummer: WO 2010/046241

(56) Entgegenhaltungen:
- WO-A1-03/065779
- WO-A1-2004/001848
- WO-A1-2004/089048
- WO-A1-2008/138011
- DE-U1-202009 009 950
- US-A1- 2006 216 854

## Beschreibung

Die Erfindung betrifft ein Verfahren zur Herstellung einer elektrischen Schaltungsanordnung mit einer Leiterplatine, die mindestens einen elektrisch leitfähigen, mit einer nichtleitenden Schicht versehenen Träger und mindestens ein auf den Träger aufgebrachtes Bauelement aufweist.

### Stand der Technik

Elektrische Schaltungsanordnungen der eingangs genannten Art sind bekannt. Beispielsweise sind Leiterplatten beziehungsweise -platinen weit verbreitet. Diese bestehen aus einem leitfähigen Träger, beispielsweise auf Metallbasis, der eine nichtleitende Schicht aufweist. Der Träger beziehungsweise der leitende Teil des Trägers kann dabei Leiterbahnen und -flächen zur elektronischen Verbindung von Bauelementen aufweisen. Weit verbreitet sind auch Leiterplatten für elektronische Schaltungen, die eingebettete Bauelemente aufweisen und in einer planaren Ausführungsform vorliegen. Das bedeutet, dass die Leiterplatte, also der elektrisch leitfähige Träger und die nichtleitende Schicht, planar ausgebildet ist. In vielen Anwendungen ist es jedoch wünschenswert, die Leiterplatte in eine von der planaren Ausbildung abweichende Form zu bringen. Beispielsweise kann eine dreidimensional frei ausgebildete Gestaltung erwünscht sein. Zu diesem Zweck wird die Leiterplatine vor einem Bestücken mit dem Bauelement in die gewünschte Form gebracht und anschließend mit dem mindestens einen Bauelement versehen. Diese Vorgehensweise hat jedoch den Nachteil, dass komplexe Schaltungsanordnungen sehr aufwendig zu fertigen sind. Insbesondere ist es auf diese Weise kaum möglich, mehrschichtige Schaltungsanordnungen herzustellen, die eine beliebige Form aufweisen. Dies gilt auch für Schaltungsanordnungen, welche mit integrierten Bauelementen versehen werden sollen.

Dokumente WO 03/065779 A1 , WO 2004/089048 A1 und US 2006/216854 A1 offenbaren Verfahren zur Einbettung von Bauelementen in eine Leiterplatte. US 2006/216854 A1 offenbart dabei die Verwendung eines Thermoplastmaterials für eine Höhenausgleichsschicht.

### Offenbarung der Erfindung

Demgegenüber weist die nach dem Verfahren des Anspruchs 1 hergestellte elektrische Schaltungsanordnung den Vorteil auf, dass eine erhebliche gesteigerte Flächennutzung der elektrischen Schaltungsanordnung realisierbar ist, indem die Leiterplatine auf engstem Raum mit Bauelementen bestückt werden kann, auch wenn eine Schaltungsanordnung beziehungsweise eine Leiterplatte mit beliebiger Formgebung hergestellt werden soll. Dies wird erreicht, indem die Schaltungsanordnung in planarer Form hergestellt und nach der Herstellung in eine nichtplanare Form verformt wird und/oder verformbar ist. Die Schaltungsanordnung wird also zunächst in planarer Form hergestellt. Dabei wird der elektrisch leitfähige Träger, der mit einer nichtleitenden Schicht versehen ist, bereitgestellt und mit Bauelementen bestückt. Anschließend wird die elektrische Schaltungsanordnung in eine dauerhafte, nichtplanare Form gebracht. Alternativ kann auch vorgesehen sein, dass die Schaltungsanordnung nach der Herstellung verformbar ist beziehungsweise bleibt. Die Bauelemente können entweder auf den leitenden Teil des Trägers oder auf dessen nichtleitende Schicht aufgebracht werden. Das Bauteil ist dabei nicht notwendigerweise ein elektrisches Bauteil, welches mit dem elektrisch leitfähigen Teil des Trägers verbunden wird. Durch die plastische Formgebung werden der Träger und dessen nichtleitende Schicht erst nach dem Bestücken mit dem Bauelement in die dreidimensionale Form gebracht. Mittels spezieller Kontaktier- und Verkapselungsprozesse ist auch die Integration von Bauelementen in die Schaltungsanordnung möglich. Das Verformen der Schaltungsanordnung kann, beispielsweise bei Einsatz von plastisch verformbaren Trägermaterialien und entsprechend gestalteten Strukturen, unter Einsatz von Kraft und gegebenenfalls Wärme, insbesondere flexibel, verformt werden.

Eine Weiterbildung der Erfindung sieht vor, dass die Schaltungsanordnung flexibel ausgebildet ist. Die Schaltungsanordnung ist somit so ausgebildet, dass sie verformbar sind und nach einer Verformung die vorliegende Form bis zu einer erneuten Verformung einhält.

Die Erfindung sieht vor, dass der Träger eine Trägerfolie ist. Der Träger ist also vergleichsweise dünn ausgebildet, sodass er folienartig ist.

Beispielsweise kann als Träger eine Metallfolie oder ein Blech vorgesehen sein. Da der Träger elektrisch leitfähig ist, ist er beispielsweise aus Kupfer ausgebildet. Es sind jedoch auch andere elektrisch leitfähige Materialien verwendbar.

Die Erfindung sieht mindestens eine an dem Träger vorgesehene Passermarke vor. An dem Träger ist mindestens eine Justagemarke, eine sogenannte Passermarke, vorgesehen. Diese erlaubt ein Bestücken des Trägers beziehungsweise dessen nichtleitender Schicht mit dem Bauelement in einer exakten Positionierung. Mittels der Passermarke ist die genaue Position des Bauelements bekannt. Damit kann zu einem späteren Zeitpunkt ohne Weiteres eine Kontaktierung des Bauelements vorgenommen werden, ohne dass das Bauelement unmittelbar erkennbar sein muss. Das Bauelement kann also in die elektrische Schaltungsanordnung integriert sein oder sich auf einer Seite der Leiterplatine befinden, wobei trotzdem eine Kontaktierung beziehungsweise eine Verbindung zu dem Bauelement auch von der anderen Seite der Leiterplatte möglich ist. Die Passermarke kann beispielsweise durch Ätzen, Stanzen und/oder Bohren hergestellt sein. Vorteilhafterweise sind mindestens zwei Passermarken vorgesehen, um die Position des Bauelements und/oder die Drehlage der Leiterplatte bestimmen zu können.

Eine Weiterbildung der Erfindung sieht vor, dass mittels der Passermarke die Position des Bauelements bestimmbar ist. Mit Hilfe der Passermarke kann die Position des Bauelements bestimmt werden, auch wenn dieses nicht sichtbar beziehungsweise erkennbar ist. Beispielsweise kann so eine Kontaktierung des Bauelements von der dem Bauelement abgewandten Seite der Leiterplatine und/oder des Bauelements in einer mehrschichtigen Anordnung erfolgen.

Eine Weiterbildung der Erfindung sieht vor, dass das Bauelement ein elektronisches oder mechanisches Bauteil ist. Das Bauteil kann sowohl auf den elektrisch leitfähigen Teil des Trägers als auch auf die nichtleitende Schicht aufgebracht sein. Es sind sowohl elektrische als auch mechanische Bauteile verwendbar. Das elektronische Bauteil kann beispielsweise ein IC, eine Flexbatterie oder ein Energieerzeuger (insbesondere polymere Solarzelle) sein. Als mechanisches Bauteil kann vor Allem ein Montageelement vorgesehen sein.

Eine Weiterbildung der Erfindung sieht mehrere, in Lagen angeordnete Träger vor. Die elektrische Schaltungsanordnung weist somit nicht einen einzelnen elektrisch leitfähigen Träger, sondern mehrere, in Lagen angeordnete Träger auf. Dabei kann jedem Träger mindestens ein Bauelement zugeordnet sein. Auf diese Weise lassen sich mehrlagige elektrische Schaltungsanordnungen herstellen, die zunächst in planarer Form hergestellt und nach der Herstellung in die nichtplanare Form verformt werden und/oder verformbar sind. Dabei sind prinzipiell beliebig viele Träger in Lagen anordenbar.

Die Erfindung sieht vor, dass der Träger Kupfer und/oder die nichtleitende Schicht ein Thermoplast und/oder ein plastisch oder elastisch verformbares Material, insbesondere Silikon, aufweist oder darauf besteht/bestehen. Es ist also vorgesehen, dass der Träger aus Kupfer besteht oder Kupfer aufweist. Die nichtleitende Schicht weist beispielsweise ein Thermoplast auf oder besteht daraus. Ebenso ist ein plastisch oder elastisch verformbares Material möglich. Besonders vorteilhaft lässt sich hierzu Silikon verwenden. Die Schaltungsanordnung kann auch mit stretchbaren oder plastisch verformbaren Trägermaterialien ausgebildet werden. Bei einer entsprechenden Struktur des Trägers ist so eine Verformung der Schaltungsanordnung in alle Raumrichtungen möglich.

Eine Weiterbildung der Erfindung sieht vor, dass die Leiterplatte zumindest einen Teil eines Gehäuses ausbildet. Die Schaltungsanordnung kann beispielsweise nach der Herstellung einem Prägeprozess unterworfen werden. Auf diese Weise ist es möglich, sie in eine Form zu bringen, die einen Einsatz der Schaltungsanordnung als Gehäuse beziehungsweise Gehäuseteil ermöglicht. Das heißt, dass durch den Einsatz von der verformten beziehungsweise verformbaren Schaltungsanordnung Teile eines Gehäuses ersetzt werden können, wobei die Schaltungsanordnung gleichzeitig eine integrierte Elektronik aufweist und durch Kleben oder Prägen mit weiteren Gehäusebestandteilen verbunden ist. Es ist auch ein elektrischer Kontakt zu weiteren Gehäusebestandteilen möglich, indem der elektrisch leitfähige Träger Kontaktstellen ausbildet, die mit den weiteren Gehäusebestandteilen in Kontakt treten können.

Eine Weiterbildung der Erfindung sieht vor, dass das Bauelement mittels eines Heiß- und/oder Druckprozesses, insbesondere Heatsealen, auf dem Träger aufgebracht ist. Beispielsweise kann der Träger mit einem wärmeempfindlichen Klebstoff versehen sein. Auf diese Weise ist es möglich, das Bauelement zu erwärmen und auf den Träger aufzubringen. Vorzugsweise wird Klebstoff verwendet, welcher unter Wärmeeinfluss aushärtet. Damit wird durch das Aufbringen des Bauteils auf den Träger eine Verbindung zwischen diesen hergestellt. Es kann auch vorgesehen sein, dass zunächst das Bauelement auf den Träger aufgebracht wird und anschließend die ausgerichtete Verbindung erwärmt und, vorzugsweise unter Einwirkung von Druck, eine elektrische und mechanische Verbindung hergestellt wird. Diese Kombination von Heiß- und Druckprozess wird als Heatsealen bezeichnet. Das Bauelement kann also durch Heiß- oder Druckprozesse beziehungsweise einer Kombination aus diesen auf den Träger aufgebracht werden. Dabei ist sowohl ein Aufbringen auf den elektrisch leitfähigen Träger als auch auf dessen nichtleitende Schicht möglich. Die elektronischen und/oder mechanischen Bauelemente werden also auf den Träger aufgeklebt, wobei - im Fall der elektronischen Bauelemente - die aktive Seite zu dem Träger zeigt.

Eine Weiterbildung der Erfindung sieht vor, dass das Bauelement starr oder verformbar ist. Auf den Träger können herkömmliche, starre Bauelemente aufgebracht werden. Es sind jedoch auch verformbare, also beispielsweise flexible und/oder dünne Bauelemente, möglich. Durch den Einsatz verformbarer Bauelemente, wie beispielsweise abgedünnter ICs, insbesondere Si-ICs, Flexbatterien, Energieerzeuger (zum Beispiel polymere Solarzellen), kann eine vollkommen verformbar Schaltungsanordnung hergestellt werden. Gleichzeitig können die Bauelemente vollständig in die Schaltungsanordnung integriert sein. Das bedeutet, dass das Bauelement vollständig verdeckt in der Schaltungsanordnung angeordnet ist.

Eine Weiterbildung der Erfindung sieht vor, dass das Bauelement eingegossen, insbesondere umspritzt, ist. Beispielsweise um das Bauelement vor äußeren Einflüssen zu schützen, kann es eingegossen werden. Dies ist insbesondere dann von Vorteil, wenn starre Bauelemente verwendet werden, das Eingießen kann jedoch auch für (flexibel) verformbare Bauelemente vorgesehen sein. Beispielsweise kann das Bauelement umspritzt werden. Dies kann in Form eines Umspritzens mit einer Epoxy-Niederdruckpressmasse ausgeführt sein. Dieses Vorgehen wird als Ummolden bezeichnet, wobei die Niederdruckpressmasse ein sogenannter "Molding Compound" ist. Generell ist das Umspritzen beziehungsweise das Eingießen mit beliebigen dazu vorgesehenen Materialien möglich, beispielsweise einem Duroplast.

Die Erfindung sieht vor, dass auf der dem Träger gegenüberliegenden Seite des Bauelements eine Abdeckung vorgesehen ist. Der mit Bauelementen versehene Träger wird so mit der Abdeckung versehen, dass die Bauelemente vor äußeren Einflüssen geschützt sind. Beispielsweise wird eine flexible und plastisch verformbare Folie auf den Träger und/oder die Bauelemente auflaminiert. Die Abdeckung ist somit so angeordnet, dass die Bauelemente zwischen dem Träger und der Abdeckung angeordnet sind.

Die Erfindung sieht vor, dass zwischen dem Träger und einem weiteren Träger und/oder der Abdeckung ein Höhenausgleich, insbesondere mittels Ein- und Aufbringen eines Thermoplastmaterials, vorgesehen ist. Die Schaltungsanordnung kann so ausgebildet sein, dass mehrere Träger vorgesehen sind. In diesem Fall ist zwischen dem Träger und dem weiteren Träger ein Höhenausgleich vorgesehen. Der Höhenausgleich kann auch zwischen dem Träger oder dem weiteren Träger und der Abdeckung vorgesehen sein. Der Höhenausgleich dient dazu, einen durch das Bauelement beziehungsweise die Bauelemente verursachten Höhenunterschied auszugleichen. Es soll also ein gleichmäßiger Verlauf des weiteren Trägers und/oder der Abdeckung sichergestellt sein. Auf diese Weise wird auch eine einfache Befestigung des weiteren Trägers und/oder der Abdeckung ermöglicht, indem diese an dem Höhenausgleich befestigt werden. Die Bauelemente werden dabei von dem Höhenausgleich eingefasst. Der Höhenausgleich kann beispielsweise durch Ein- und/oder Aufbringen des Thermoplastmaterials hergestellt werden. Das bedeutet, dass auf den Träger oder den weiteren Träger der Höhenausgleich, beispielsweise in Form des Thermoplastmaterials, aufgebracht wird, bis ein einfaches Befestigen des weiteren Trägers und/oder der Abdeckung möglich ist.

Die Erfindung sieht vor, dass mindestens eine Ausnehmung in dem Träger und/oder der nichtleitenden Schicht und/oder der Abdeckung, insbesondere zur elektrischen Kontaktierung des Bauelements, vorgesehen ist. Um den elektrischen Kontakt zu dem Bauelement herzustellen, sind die Ausnehmungen in dem Träger, der nichtleitenden Schicht und/oder der Abdeckung vorgesehen. Diese können beispielsweise als Löcher vorliegen, die insbesondere durch Laserbohren hergestellt sind. Bei dem Anbringen der Ausnehmungen können beispielsweise die Passermarken berücksichtigt werden, um eine äußerst genaue Positionierung der Ausnehmung zu ermöglichen.

Die Erfindung sieht vor, dass eine elektrische Verbindung des Bauelements mittels Metallabscheidung und/oder mittels mindestens einer polymeren Leiterbahn hergestellt ist. Die elektrische Verbindung des Bauelements kann vorteilhafterweise in der Ausnehmung hergestellt sein, die Verbindung bedeutet also eine Kontaktierung des Bauelements. Das heißt, dass die Ausnehmungen metallisiert werden. Dies geschieht mittels der Metallabscheidung. Alternativ oder zusätzlich kann es vorgesehen sein, eine Leiterbahn aus einem polymeren Material zu verwenden. Diese kann insbesondere aus leitfähiger Tinte bestehen.

Eine Weiterbildung der Erfindung sieht vor, dass eine Oberseite und/oder eine Unterseite der Leiterplatte mindestens ein weiteres Bauelement aufweist. Die Leiterplatte beziehungsweise der Träger kann also beidseitig bestückt sein. Das weitere Bauelement kann auch auf der Abdeckung oder dem weiteren Träger angeordnet sein. Die Schaltungsanordnung kann also sowohl integrierte Bauelemente, also von außen nicht sichtbare Bauelemente, aufweisen, als auch solche, die auf der Oberseite und/oder der Unterseite angeordnet sind. Dies erlaubt eine weitere Erhöhung der Packungsdichte der Bauelemente, womit auf engstem Raum elektronische und mechanische Bauelemente angeordnet sein können.

Die Erfindung betrifft ein Verfahren zum Herstellen einer elektrischen Schaltungsanordnung, insbesondere gemäß den vorhergehenden Ausführungen, wobei die Schaltungsanordnung eine Leiterplatte mit mindestens einem mit einer nichtleitenden Schicht versehenen Träger und mindestens einem auf dem Träger aufgebrachten Bauelement aufweist. Dabei ist vorgesehen, dass die Schaltungsanordnung in planarer Form gefertigt wird und nach dem Fertigen in eine nichtplanare Form verformt wird und/oder verformbar ist. Die Herstellung der Schaltungsanordnung erfolgt also zunächst mit einer planaren Formgebung. Anschließend wird die Schaltungsanordnung, beispielsweise unter Einsatz von Kraft und/oder Temperatur verformt, sodass eine nichtplanare Form vorliegt. Es ist jedoch alternativ auch vorgesehen, dass die Schaltungsanordnung nach dem Herstellen verformbar bleibt.

Die Erfindung sieht vor, dass das Herstellen der elektrischen Schaltungsanordnung mit den vorliegenden Schritten durchgeführt wird: Bereitstellen des Trägers und des mindestens einen Bauelements, Anbringen von mindestens einer Passermarke an dem Träger, insbesondere mittels Ätzen und/oder Stanzen und/oder Bohren, Aufbringen der Bauelemente auf den Träger, Aufbringen eines Höhenausgleichs zum Nivellieren des Trägers mit dem Bauelement und Aufbringen eines weiteren Trägers und/oder einer Abdeckung, Einbringen von mindestens einer Ausnehmung in den Träger und/oder die nichtleitende Schicht, insbesondere zum Herstellen einer elektrischen Kontaktierung des Bauelements, relativ zu der Passermarke, Metallisieren der Ausnehmung mittels Metallabscheidung und/oder der Strukturierung der Leiterplatine, sowie Verformung der Schaltungsanordnung. Nach dem Bereitstellen des Trägers wird also zunächst die Passermarke an den Träger angebracht. Das Bauelement wird nun derart auf den Träger aufgebracht, sodass seine Position relativ zu der Passermarke genau bekannt ist. Mittels der Passermarke kann somit später die Ausnehmung zur Kontaktierung des Bauelements mit großer Präzision hergestellt werden. Nach dem Aufbringen des Bauelements auf den Träger wird der Höhenausgleich auf diesem aufgebracht. Der Höhenausgleich dient dazu, eine einheitliche Höhe des Trägers mit dem Bauelement herzustellen, um ein einfaches Aufbringen des weiteren Trägers und/oder der Abdeckung zu ermöglichen. Insbesondere dient der Höhenausgleich zum Ausgleichen von unterschiedlichen Höhen von mehreren Bauelementen. Anschließend erfolgt das Aufbringen des weiteren Trägers, in dem Fall, dass eine mehrschichtige Schaltungsanordnung hergestellt werden soll. Als letzte Schicht wird üblicherweise die Abdeckung angeordnet, die beispielsweise ebenfalls in Form einer Leiterplatte vorliegt. Soll das Bauelement, , insbesondere elektrisch, kontaktiert werden, so wird relativ zu der Passermarke die mindestens eine Ausnehmung eingebracht. Dabei durchgreift die Ausnehmung zumindest den Träger und/oder die nichtleitende Schicht. Die Ausnehmung wird anschließend mittels Metallabscheidung metallisiert. Sie wird also im Wesentlichen wiederum mit einem metallischen Material verschlossen, wobei die elektrische Kontaktierung des Bauelements hergestellt wird. Auch kann nun das Strukturieren der Leiterplatine erfolgen, wobei der elektrisch leitfähige Träger entsprechend der Funktion der Schaltungsanordnung strukturiert wird. Beispielsweise können polymere Leiterbahnen zu diesem Zweck verwendet werden. Zur Bildung der polymeren Leiterbahnen können leitfähige Tinten und andere geeignete Materialien zum Einsatz kommen. Die vorstehend genannten Schritte werden so oft wiederholt, bis die endgültige Schaltungsanordnung vorliegt. Auf diese Weise können auch mehrschichtige Schaltungsanordnungen gefertigt werden, die mehrere, in Lagen angeordnete Träger aufweisen. Die Schritte werden somit solange durchgeführt, bis die Schaltungsanordnung mit vollständiger Funktionalität vorliegt. Anschließend wird die Schaltungsanordnung verformt. Dabei ist es nicht notwendig, dass auch das Bauelement verformt wird. Dies kann jedoch vorgesehen sein, beispielsweise wenn das Bauelement flexibel verformbar oder vergleichsweise dünn ist.

Eine Weiterbildung der Erfindung sieht vor, dass das Bauelement eingegossen, insbesondere umspritzt, wird. Dies wird speziell bei empfindlichen und/oder nicht verformbaren, also starren, Bauelementen durchgeführt. Vorzugsweise erfolgt das Eingießen beziehungsweise Umspritzen in Form von Ummolden, das Bauelement soll also mit einer Epoxy-Niederdruckpressmasse umspritzt werden.

Eine Weiterbildung der Erfindung sieht vor, dass eine Oberseite und/oder eine Unterseite der Leiterplatte und/oder der Abdeckung mit mindestens einem weiteren Bauelement versehen wird. Neben den in der Schaltungsanordnung integrierten Bauelementen sind also auch solche Bauelemente vorgesehen, die auf der Oberseite und/oder der Unterseite der Leiterplatte und/oder der Abdeckung angeordnet sind.

Eine Weiterbildung der Erfindung sieht vor, dass die Schaltungsanordnung so verformt wird, dass sie zumindest einen Teil eines Gehäuses ausbildet. Nach dem Fertigen der Schaltungsanordnung kann es vorgesehen sein, diese zu verformen und in ein Gehäuse einzupassen beziehungsweise so auszugestalten, dass die Schaltungsanordnung einen Teil des Gehäuses bildet.

Eine Weiterbildung der Erfindung sieht vor, dass die Leiterplatte während des Herstellens auf Maß gebracht wird. Während des Herstellens kann die Leiterplatte auf Leiterplatten-, Substrat- oder Gehäusemaß zugeschnitten werden. Das bedeutet, dass sie auf ein Maß gebracht wird, welches den endgültigen Abmessungen der Schaltungsanordnung entspricht.

### Kurze Beschreibung der Zeichnungen

Die Erfindung wird anhand der in der Zeichnung dargestellten Ausführungsbeispiele näher erläutert. Dabei zeigen:
- Figur 1: eine elektrische Schaltungsanordnung mit einer nichtplanaren Form, die eine Leiterplatine sowie mehrere Bauelemente aufweist,
- Figuren 2 bis 6: Herstellungsschritte der elektrischen Schaltungsanordnung mit flexibel verformbaren und dünnen Bauelementen,
- Figuren 7 bis 9: alternative Herstellungsschritte der elektrischen Schaltungsanordnung mit starren Bauelementen.

### Ausführungsform(en) der Erfindung

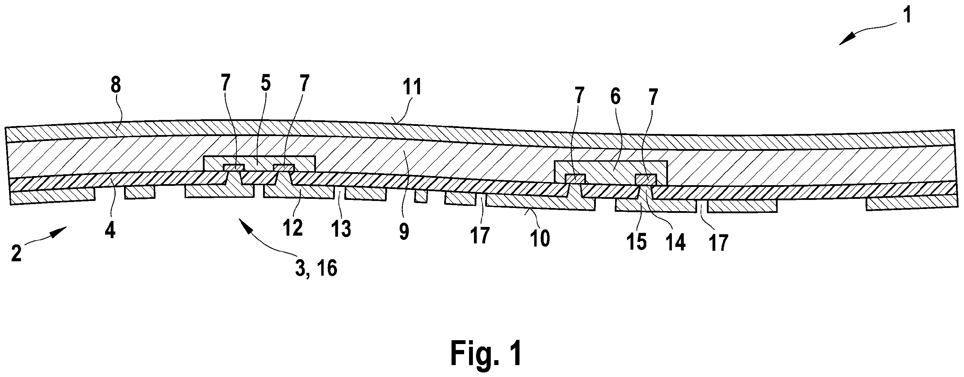

Die Figur 1 zeigt eine elektrische Schaltungsanordnung 1 mit einer Leiterplatte 2. Diese weist einen elektrisch leitfähigen Träger 3 auf, der mit einer nichtleitenden Schicht 4 versehen ist. Auf die Schicht 4 sind ein erstes Bauelement 5 und ein zweites Bauelement 6 aufgebracht, die jeweils über zwei Kontaktstellen 7 verfügen. Auf der dem Träger 3 gegenüberliegenden Seite der Bauelemente 5 und 6 ist eine Abdeckung 8 aufgebracht. Zwischen dem Träger 3 und der Abdeckung 8 ist ein Höhenausgleich 9 vorgesehen, der den Raum zwischen dem Träger 3 und der Abdeckung 8 ausfüllt und dabei die unterschiedlichen Höhen des ersten Bauelements 5 und des zweiten Bauelements 6 ausgleicht. Die Höhe des Höhenausgleichs 9 beziehungsweise der Abstand zwischen dem Träger 3 und der Abdeckung 8 ist derart bemessen, dass auch bei einer Verformung der elektrischen Schaltungsanordnung 1 der Ausgleich der unterschiedlichen Höhen gewährleistet ist. Auf einer Unterseite 10 der Leiterplatte 2 und/oder einer Oberseite 11 der Abdeckung 8 können weitere Bauelemente (nicht dargestellt) vorgesehen sein. Der Träger 3 besteht aus einem elektrisch leitfähigen Material, beispielsweise Kupfer. Ebenso kann die Abdeckung 8 aus demselben elektrisch leitfähigen Material bestehen. Die nichtleitende Schicht 4 kann beispielsweise ein Thermoplast beziehungsweise ein plastisch oder elastisch verformbares Material aufweisen oder daraus bestehen. Daher können die Bauelemente 5 und 6 mittels Heiß- und/oder Druckprozessen auf die Leiterplatte 2 aufgebracht werden. Besonders vorteilhaft kann dabei Heatsealen angewandt werden.

Der Träger 3 ist strukturiert, das heißt, er weist Leiterbahnen 12 auf. Zwischen den Leiterbahnen 12 sind Ausnehmungen 13 in den Träger 3 eingebracht. Der Träger 3 bildet also den leitfähigen Teil der elektrischen Schaltungsanordnung 1 aus. Die nichtleitende Schicht 4 weist Ausnehmungen 14 auf, die mittels Metallabscheidung mit Kontakten 15 versehen wurde, die eine elektrische Verbindung von dem Träger 3 zu den Kontaktstellen 7 des ersten Bauelements 5 und des zweiten Bauelements 6 ausbilden. Der Träger 3 kann beispielsweise als Trägerfolie 16 ausgebildet sein. In dem Träger 3 sind zudem Passermarken 17 vorgesehen, welche eine exakte Anbringung der Ausnehmungen 14 erlaubt, da die Position der Bauelemente 5 und 6 zu den Passermarken 17 bekannt ist. Vorteilhafterweise sind zwei Passermarken 17 vorgesehen, um die Lage der Bauelemente 5 und 6 und/oder die Drehlage der Leiterplatte 2 beziehungsweise des Trägers 3 bestimmen zu können. Die Bauelemente 5 und 6 können sowohl elektronische als auch mechanische Bauteile sein. Es können sowohl aktive als auch passive Bauteile vorgesehen sein. Mechanische Bauteile sind häufig als Montageelemente (nicht dargestellt) ausgebildet. Als elektronische Bauelemente können beispielsweise Widerstände, ICs, Flexbatterien, Energieerzeuger, wie beispielsweise polymere Solarzellen (in einer dritten Ebene der elektronischen Schaltungsanordnung 1), vorgesehen sein.

Anstatt der Abdeckung 8 kann auch eine weitere Leiterplatte 2 vorgesehen sein, sodass mehrlagige elektrische Schaltungsanordnungen 1 herstellbar sind. Nach einem Fertigen der elektrischen Schaltungsanordnung 1 kann die Schaltungsanordnung 1 verformt werden. Alternativ kann sie auch so ausgestaltet sein, dass sie verformbar ist. Bei dem Verformen der elektrischen Schaltungsanordnung 1 müssen die Bauelemente 5 und 6 nicht notwendiger Weise ebenfalls verformt werden. Dies ist lediglich für, insbesondere flexibel, verformbare und/oder dünne Bauelemente 5 und 6 vorgesehen. Es können jedoch auch starr ausgebildete Bauelemente 5 und 6 vorgesehen sein, die nicht verformt werden. Die Leiterbahnen 12 können als polymere Leiterbahnen ausgebildet sein beziehungsweise durch polymere Leiterbahnen ergänzt werden. Diese können beispielsweise aus leitfähiger Tinte bestehen.

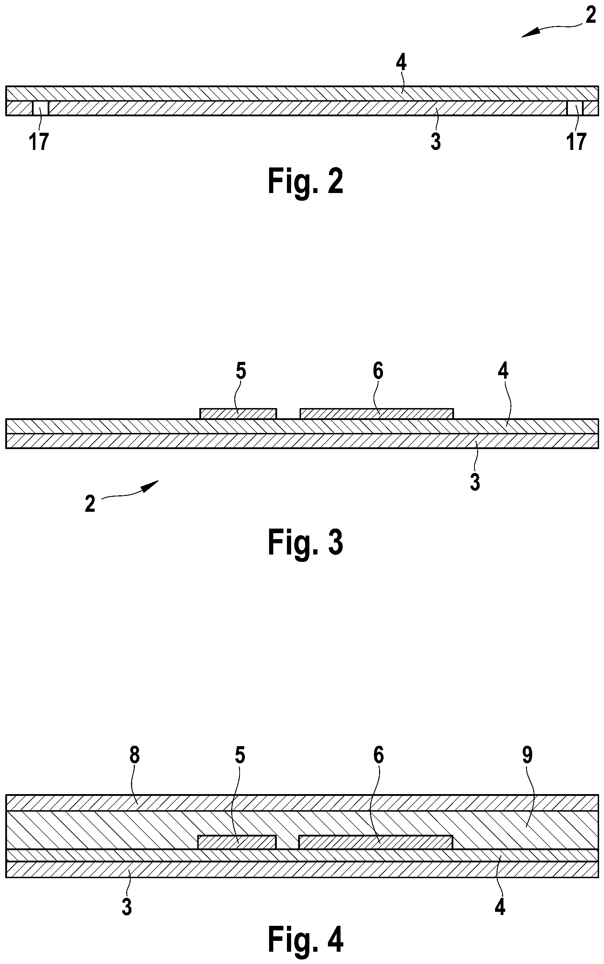

Die Figuren 2 bis 6 zeigen Herstellungsschritte der elektrischen Schaltungsanordnung 1. Zunächst wird, wie in Figur 2 dargestellt, der Träger 3 bereitgestellt und mit Passermarken 17 versehen. Wie vorstehend beschrieben, weist die Leiterplatte 23 den Träger 3 auf, auf welchen die nichtleitende Schicht 3 aufgebracht ist. In Figur 3 ist dargestellt, dass auf die nichtleitende Schicht 4 ein erstes Bauelement 5 und ein zweites Bauelement 6 aufgebracht werden. Dies geschieht mit Vorteil durch einen Heatsealing-Prozess. Das bedeutet, dass die nichtleitende Schicht 4 mit einem Klebstoff versehen wird, der auf Wärme reagiert. Die Bauelemente 5 und 6 können nun auf die nichtleitende Schicht 4 aufgebracht werden, die Kontaktstellen erwärmt und die Bauelemente 5 und 6 unter Druck mit der Schicht 4 verbunden werden. Wie in Figur 4 dargestellt wird anschließend ein Höhenausgleich 9 aufgebracht, der an die nichtleitende Schicht 4 anschließt und die Bauelemente 5 und 6 einschließt. Auf diese Weise werden Höhenunterschiede zwischen den Bauelementen 5 und 6 beseitigt. Das heißt, dass der Träger 3 und die Bauelemente 5 und 6 nivelliert werden.

Auf den Höhenausgleichen 9 wird anschließend eine Abdeckung 8 aufgebracht. Dies kann beispielsweise geschehen, indem eine flexible und plastisch verformbare Folie auflaminiert wird. Es kann vorgesehen sein, dass die Abdeckung 8 aus demselben Material wie der Träger 3 beziehungsweise die Trägerfolie 16 besteht.

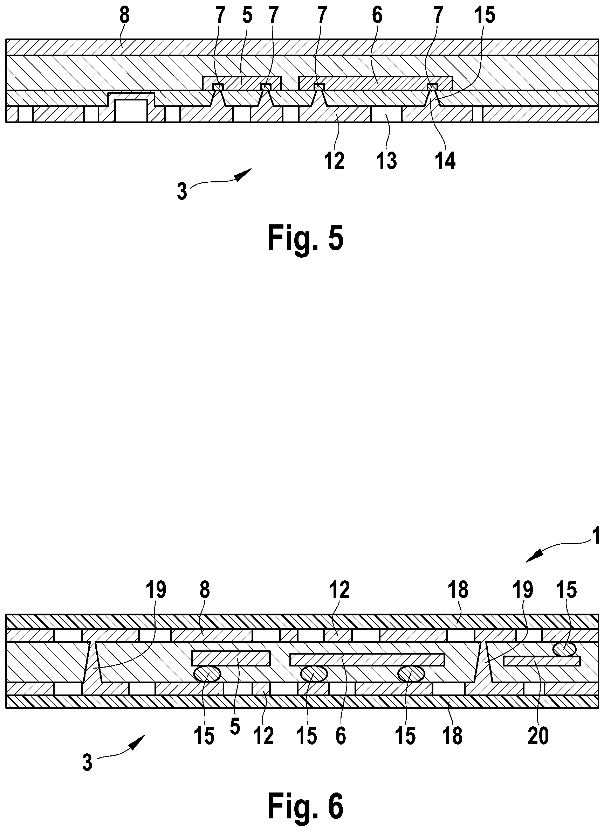

Figur 5 zeigt, dass anschließend dem Aufbringen der Abdeckung 8 der Träger 3 strukturiert, also mit Leiterbahnen 12 versehen, wird. Dies geschieht, indem Ausnehmungen 13 in dem Träger 3 ausgebildet werden. Vor oder anschließend dem Ausbilden der Ausnehmungen 13 werden in dem Träger 3 und der nichtleitenden Schicht 4 Ausnehmungen 14 ausgebildet, die der Kontaktierung der Bauelemente 5 und 6 dienen. Diese werden relativ zu den Passermarken 17 angeordnet, die hier nicht dargestellt sind. Die Ausnehmungen 14 werden anschließend mittels Metallisierung ausgefüllt, sodass Kontakte 15 ausgebildet werden, die den Träger 3 elektrisch mit den Kontaktstellen 7 der Bauelemente 5 und 6 verbindet. Auf diese Weise ist der elektrische Kontakt zu den Bauelementen 5 und 6 hergestellt. Wie in Figur 6 dargestellt, können anschließend optional Isolationsschichten 18 aufgebracht werden. Diese können zum Anbringen von Steckverbindern oder Kabeln strukturiert sein.

Vorausgehend kann die Abdeckung 8 analog zu dem Träger 3 strukturiert worden sein, das heißt Leiterbahnen 12 aufweisen. Es kann auch vorgesehen sein, dass ein elektrischer Kontakt zwischen verschiedenen Schichten, beispielsweise dem Träger 3 und der Abdeckung 8 hergestellt ist. Zu diesem Zweck sind Verbindungskontakte 19 vorgesehen, die ebenfalls mittels Metallabscheidung hergestellt sind, wobei vorhergehend eine entsprechende Ausnehmung eingebracht wurde. In dem dargestellten Beispiel sind drei Bauelemente 5, 6 und 20 dargestellt, welche mittels Kontakten 15 elektrisch kontaktiert sind. Anschließend dem Fertigen der elektrischen Schaltungsanordnung 1 kann diese verformt werden, wie beispielsweise in der Figur 1 dargestellt, oder verformbar ausgebildet sein.

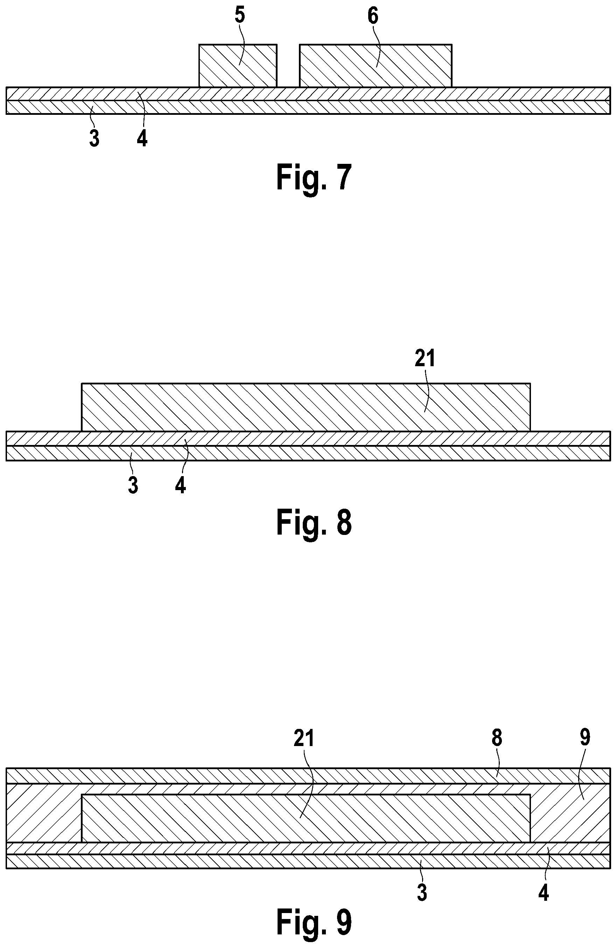

Die Figuren 7 bis 9 zeigen alternative Fertigungsschritte, falls starre Bauelemente 5 und 6 vorgesehen sind. Wie in Figur 7 dargestellt, werden die Bauelemente 5 und 6 analog zu der Figur 3 auf die nichtleitende Schicht 4 aufgebracht. Diese ist auf dem Träger 3 angeordnet. Das Befestigen der Bauelemente 5 und 6 geschieht wiederum über Heatsealen. Anschließend werden die Bauteile ummoldet, das heißt mit einem Duroplast, beispielsweise einer Epoxy-Niederdruckpressmasse, umspritzt. Damit sind die Bauelemente 5 und 6 in einer Umfassung 21 eingegossen. Das Eingießen beziehungsweise Umspritzen der Bauelemente 5 und 6 mit der Umfassung 21 stabilisiert die Bauelemente 5 und 6 und verhindert ein Verformen von diesen. Wie in Figur 9 dargestellt, wird anschließend die Umfassung 21 in einen Höhenausgleich 9 eingebettet und anschließend eine Abdeckung 8 aufgebracht. Dieser Schritt ist analog zu dem in Figur 4 für die dünnen und flexiblen Bauelemente dargestellt. Das weitere Verfahren für die starren Bauelemente 5 und 6, wie in den Figuren 7 bis 9 dargestellt, entspricht dem in den Figuren 5 und 6 für die flexiblen und dünnen Bauelemente 5 und 6 dargestellten. Der Träger 3 wird also strukturiert, indem Ausnehmungen 13 eingebracht werden. Ebenso werden Ausnehmungen 14 gebildet, die anschließend mittels Metallabscheidung ausgefüllt und somit Kontakte 15 zu Kontaktstellen 7 der Bauelemente 5 und 6 hergestellt werden. Auch ein Verformen der elektrischen Schaltungsanordnung 1 ist anschließend möglich, wobei die Umfassung 21 ein Verformen der Bauelemente 5 und 6 verhindert, womit lediglich die Leiterplatte 2 der Verformung ausgesetzt ist.

Auf diese Weise ist eine kostengünstige Verkapselung von passiven und aktiven elektronischen Bauelementen 5 und 6 möglich. Dies erlaubt die Herstellung von elektrischen Schaltungsanordnungen 1, die sehr zuverlässig sind. Insgesamt ergeben sich Schaltungsanordnungen 1, in die die Bauelemente 5 und 6 integriert sind. Durch den Einsatz von plastisch verformbaren Materialien, beispielsweise Kupfer für den Träger 3 und für die Metallisierung und Thermoplasten für die Schicht 4, kann eine dauerhaft formstabile elektrische Schaltungsanordnung 1 erzeugt werden. Durch den Einsatz flexibler Elektronik können aber auch komplett flexible und verformbare elektrische Schaltungsanordnungen 1 hergestellt werden. Ebenso wird zusätzliche Verdrahtungsfläche geschaffen durch die Integration kompletter Bestückebenen in die Leiterplatte 2. Die Verformung der elektrischen Schaltungsanordnung 1 nach der Herstellung in planarer Form ermöglicht eine deutliche Reduktion der Herstellungskosten. Werden sehr dünne ICs verwendet, ist auch eine Verformung der Bauelemente 5 und 6 in der elektrischen Schaltungsanordnung 1 möglich.

## Patentansprüche

1. Verfahren zum Herstellen einer elektrischen Schaltungsanordnung (1), die eine Leiterplatte (2) mit mindestens einem mit einer nichtleitenden Schicht (4) versehenen Träger (3), der eine Trägerfolie (16) ist, und mit mindestens einem auf dem Träger (3) aufgebrachten, flexibel verformbaren Bauelement (5,6,20) aufweist, wobei die Schaltungsanordnung (1) in planarer Form gefertigt wird und nach dem Fertigen in eine nichtplanare Form verformt wird, mit folgenden Schritten:
- Bereitstellen des Trägers (3) und des mindestens einen Bauelements (5,6,20),
- Anbringen von mindestens einer Passermarke (17) an dem Träger (3), insbesondere mittels Ätzen und/oder Stanzen und/oder Bohren,
- Aufbringen des Bauelements (5,6,20) auf die ein Thermoplast und/oder Silikon aufweisende oder daraus bestehende nichtleitende Schicht (4) des Trägers (3),
- Aufbringen eines Höhenausgleichs (9) aus Thermoplastmaterial zum Nivellieren des Trägers (3) mit dem Bauelement (5,6,20) und Aufbringen eines weiteren Trägers und/oder einer Abdeckung (8),
- Einbringen von mindestens einer Ausnehmung (14) in den Träger (3) oder die nichtleitende Schicht (4) zum Herstellen einer elektrischen Kontaktierung des Bauelements, relativ zu der Passermarke (17),
- Metallisierung der Ausnehmung (14) mittels Metallabscheidung und/oder Strukturieren der Leiterplatte (2), und
- anschließendes Verformen der Schaltungsanordnung (1) in die nichtplanare Form, wobei auch das Bauelement (5,6,20) verformt wird.

2. Verfahren nach Anspruch 1, **dadurch gekennzeichnet, dass** das Bauelement (5,6,20) eingegossen, insbesondere umspritzt, wird.

3. Verfahren nach einem der vorhergehenden Ansprüche, **dadurch gekennzeichnet, dass** eine Oberseite (11) und/oder eine Unterseite (10) der Leiterplatte (2) und/oder der Abdeckung (8) mit mindestens einem weiteren Bauelement versehen wird.

4. Verfahren nach einem der vorhergehenden Ansprüche, **dadurch gekennzeichnet, dass** die Schaltungsanordnung (1) so verformt wird, dass sie zumindest einen Teil eines Gehäuses ausbildet.

5. Verfahren nach einem der vorhergehenden Ansprüche, **dadurch gekennzeichnet, dass** die Leiterplatte (2) während des Herstellens auf Maß gebracht wird.

6. Verfahren nach einem der vorhergehenden Ansprüche, **dadurch gekennzeichnet, dass** die Schaltungsanordnung (1) flexibel ausgebildet ist.

7. Verfahren nach einem der vorhergehenden Ansprüche, **dadurch gekennzeichnet, dass** mittels der Passermarke (17) die Position des Bauelements (5,6,20) bestimmbar ist.

8. Verfahren nach einem der vorhergehenden Ansprüche, **dadurch gekennzeichnet, dass** das Bauelement (5,6,20) ein elektronisches oder mechanisches Bauteil (5,6,20) ist.

9. Verfahren nach einem der vorhergehenden Ansprüche, **gekennzeichnet durch** mehrere, in Lagen angeordnete Träger (3).

10. Verfahren nach einem der vorhergehenden Ansprüche, **dadurch gekennzeichnet, dass** das Bauelement (5,6,20) mittels eines Heiß- und/oder Druckprozesses, insbesondere Heatsealing, auf den Träger (3) aufgebracht ist.

11. Verfahren nach einem der vorhergehenden Ansprüche, **dadurch gekennzeichnet, dass** auf der dem Träger (3) gegenüberliegenden Seite des Bauelements (5,6,20) eine Abdeckung (8) vorgesehen ist.

12. Verfahren nach einem der vorhergehenden Ansprüche, **dadurch gekennzeichnet, dass** eine elektrische Verbindung des Bauelements (5,6,20) mittels mindestens einer polymeren Leiterbahn hergestellt ist.

## Claims

1. Method for producing an electrical circuit arrangement (1) comprising a circuit board (2) having at least one carrier (3) provided with a non-conductive layer (4), said at least one carrier being a carrier film (16), and having at least one flexibly deformable component (5, 6, 20) applied on the carrier (3), wherein the circuit arrangement (1) is fabricated in planar form and is deformed into a non-planar form after fabrication, having the following steps:
- providing the carrier (3) and the at least one component (5, 6, 20),
- providing at least one register mark (17) at the carrier (3), in particular by means of etching and/or stamping and/or drilling,
- applying the component (5, 6, 20) on the non-conductive layer (4) of the carrier (3), said non-conductive layer comprising or consisting of a thermoplastic and/or silicone,
- applying a height equalization (9) composed of thermoplastic material for the purpose of levelling the carrier (3) with the component (5, 6, 20) and applying a further carrier and/or a cover (8),
- introducing at least one cutout (14) into the carrier (3) or the non-conductive layer (4) for the purpose of producing an electrical contacting of the component, relative to the register mark (17),
- metallizing the cutout (14) by means of metal deposition and/or structuring the circuit board (2), and
- subsequently deforming the circuit arrangement (1) into the non-planar form, wherein the component (5, 6, 20) is also deformed.

2. Method according to Claim 1, **characterized in that** the component (5, 6, 20) is enclosed by moulding, in particular encapsulated by injection moulding.

3. Method according to either of the preceding claims, **characterized in that** a top side (11) and/or an underside (10) of the circuit board (2) and/or of the cover (8) are/is provided with at least one further component.

4. Method according to any of the preceding claims, **characterized in that** the circuit arrangement (1) is deformed such that it forms at least one part of a housing.

5. Method according to any of the preceding claims, **characterized in that** the circuit board (2) is brought to size during production.

6. Method according to any of the preceding claims, **characterized in that** the circuit arrangement (1) is formed in a flexible fashion.

7. Method according to any of the preceding claims, **characterized in that** the position of the component (5, 6, 20) is determinable by means of the register mark (17) .

8. Method according to any of the preceding claims, **characterized in that** the component (5, 6, 20) is an electronic or mechanical component (5, 6, 20).

9. Method according to any of the preceding claims, **characterized by** a plurality of carriers (3) arranged in layers.

10. Method according to any of the preceding claims, **characterized in that** the component (5, 6, 20) is applied on the carrier (3) by means of a heat and/or pressure process, in particular in a heat sealing.

11. Method according to any of the preceding claims, **characterized in that** a cover (8) is provided on the opposite side of the component (5, 6, 20) relative to the carrier (3).

12. Method according to any of the preceding claims, **characterized in that** an electrical connection of the component (5, 6, 20) is produced by means of at least one polymeric conductor track.

## Revendications

1. Procédé de fabrication d'un circuit électrique (1) comportant une carte de circuit imprimé (2) qui présente au moins un support (3) muni d'une couche non conductrice (4) et qui est un film de support (16), et au moins un composant (5, 6, 20) pouvant être soumis à une déformation flexible, qui est appliqué sur le support (3), dans lequel le circuit (1) est fabriqué sous forme plane et, après fabrication, est déformé en une forme non plane, comprenant les étapes suivantes :
- fournir le support (3) et ledit au moins un composant (5, 6, 20),
- former au moins une marque de repérage (17) sur le support (3), en particulier par gravure et/ou poinçonnage et/ou perçage,
- appliquer le composant (5, 6, 20) sur la couche non conductrice (4) du support (3), qui comporte un thermoplastique et/ou une silicone ou est constituée de ceux-ci,
- appliquer un régulateur de hauteur (9) constitué d'une matière thermoplastique pour niveler le support (3) avec le composant (5, 6, 20) et appliquer un autre support et/ou un revêtement (8),
- ménager au moins un évidement (14) dans le support (3) ou la couche non conductrice (4) pour établir un contact électrique avec le composant, par rapport à la marque de repérage (17),
- métalliser l'évidement (14) par dépôt de métal sur la carte de circuit imprimé (2) et/ou structuration de celle-ci, et
- déformer ensuite le circuit (1) pour lui conférer la forme non plane, dans lequel le composant (5, 6, 20) est également déformé.

2. Procédé selon la revendication 1, **caractérisé en ce que** le composant (5, 6, 20) est coulé, en particulier surmoulé.

3. Procédé selon l'une des revendications précédentes, **caractérisé en ce qu'**une face supérieure (11) et/ou une face inférieure (10) de la carte de circuit imprimé (2) et/ou du revêtement (8) est munie d'au moins un autre composant.

4. Procédé selon l'une des revendications précédentes, **caractérisé en ce que** le circuit (1) est déformé de manière à ce qu'il forme au moins une partie d'un boîtier.

5. Procédé selon l'une des revendications précédentes, **caractérisé en ce que** le circuit imprimé (2) est calibré pendant la fabrication.

6. Procédé selon l'une des revendications précédentes, **caractérisé en ce que** le circuit (1) est réalisé de manière flexible.

7. Procédé selon l'une des revendications précédentes, **caractérisé en ce que** la position du composant (5, 6, 20) peut être déterminée au moyen de la marque de repérage (17).

8. Procédé selon l'une des revendications précédentes, **caractérisé en ce que** le composant (5, 6, 20) est un composant électronique ou mécanique (5, 6, 20) .

9. Procédé selon l'une des revendications précédentes, **caractérisé par** une pluralité de supports (3) disposés en couches.

10. Procédé selon l'une des revendications précédentes, **caractérisé en ce que** le composant (5, 6, 20) est appliqué sur le support (3) au moyen d'un processus à chaud et/ou d'impression, notamment par thermoscellage.

11. Procédé selon l'une des revendications précédentes, **caractérisé en ce qu'**un revêtement (8) est prévu sur le côté du composant (5, 6, 20) en face du support (3).

12. Procédé selon l'une des revendications précédentes, **caractérisé en ce qu'**une connexion électrique du composant (5, 6, 20) est réalisée au moyen d'au moins une piste conductrice polymère.
